# EUROPEAN PATENT SPECIFICATION

(11) **EP 0 837 623 B1**
(45) Date of publication and mention of the grant of the patent: **18.08.2004**
(21) Application number: 97307983.3
(22) Date of filing: 09.10.1997
(51) Int. Cl.: H05K 1/16, H01C 17/18

(54) **Method for the manufacture of printed circuit boards with plated resistors**
Verfahren zur Herstellung gedruckter Leiterplatten mit plattierten Widerständen
Procédé de fabrication de panneaux à circuit imprimé avec des résistances plaquées

(30) Priority: 16.10.1996 US 732649
(43) Date of publication of application: 22.04.1998
(73) Proprietor: MACDERMID INCORPORATED, Waterbury, Connecticut 06702 (US)
(72) Inventor: Kukanskis, Peter, Woodbury, Connecticut (US); Larson, Gary B., Cheshire, Connecticut (US); Bengston, Jon, West Hartford, Connecticut 06107 (US); Schweikher, William, Wolcott, Connecticut (US)
(74) Representative: Jenkins, Peter David

(56) References cited:
- DE-A- 2 902 415
- GB-A- 1 473 223
- US-A- 3 522 085
- US-A- 5 221 418

## Description

The present invention relates to a process for the manufacture of double-sided or multilayer printed circuit boards with printed plated resistors. The method proposed produces printed circuits with integral resistors which are printed and plated in place on the surfaces of the printed circuit board. The process produces printed circuit boards with resistors in a manner that is more efficient and economical than previously possible.

In the manufacture of printed circuits, it is now commonplace to provide planar boards having circuitry on each side thereof (eg. double sided circuit boards). It is also commonplace to produce boards comprised of integral planar laminates of insulating substrate and conductive metal, wherein one or more parallel innerlayers or planes of the conductive metal, separated by insulating substrate, are present within the structure with the exposed outer surfaces, along with the inner planes, of the laminate containing printed circuit patterns (eg. multilayer circuit boards).

In double sided and multilayer circuit boards, it is necessary to provide interconnection between or among the various layers and/or sides of the board containing the conductive circuitry. This is achieved by providing metalized, conductive thru-holes in the board communicating with the sides and layers requiring electrical interconnection. The predominantly employed method for providing conductive thru-holes is by electroless deposition of metal on the non-conductive surfaces of the thru-holes which have been drilled or punched through the board Typically the clectroless deposition is followed by electrolytic deposition of metal in the holes to build conductive metal to the required thickness. Recently some processes have allowed for direct electroplating in the thru-holes without need for prior electroless deposition.

The typical manufacturing sequence for producing printed circuit boards begins with a copper-clad laminate. The copper clad laminate comprises a glass reinforced epoxy insulating substrate with copper foil adhered to both planar surfaces of said substrate, although other types of insulating substrates such as paper phenolic and polyimide, have been used. First the thru-holes are drilled or punched in the copper clad laminate thereby exposing the hole surfaces of insulating substrate material. The holes are then subjected to a chemical plating process which deposits conductive metal in the holes as well as on the copper surfaces. A plating mask is provided on the outer surfaces in the negative image of the circuitry desired. Subsequently copper is electroplated on all surfaces, not covered by the plating mask, to a predetermined thickness, followed by a thin deposition of tin to act as an etch resist. The plating resist is then stripped and the exposed copper surfaces (ie., those not plated with the etch resist) are etched away. Finally the etch resist is removed and printed circuit board is finished with one of a number of known finishing methods such as solder mask, followed by hot air solder leveling. The foregoing process is typically called the pattern plate process and is suitable for producing double sided printed circuit boards or multilayer boards. However in the case of multilayer boards, the starting material is a copper clad laminate which comprises inner planes of circuitry called innerlayers.

Simple printed circuit boards and the innerlayers of a multilayer circuit board are produced through a technique called print and etch. In this manner a photopolymer is laminated or dried on the copper surfaces of a copper clad laminate. The photopolymer is then selectively imaged using a negative and developed to produce a positive image of the desired circuit pattern on the surfaces of the copper clad laminate. The exposed copper is then etched away and the photopolymer stripped, revealing the desired circuit pattern.

The semi-additive process may be used in conjunction with the print and etch process to produce double sided or multilayer print and etch boards with plated thru-holes. In this process a copper clad laminate or a multilayer package with copper foil on the exterior surfaces is processed through the print and etch process as given above. Holes are then drilled in the board in a desired array. A plating resist is then applied to cover substantially the entire outer surfaces of the board except for the holes and the circuits. The exposed areas are then plated electrolessly.

In addition to the foregoing, many other processes have been utilized to produce printed circuit boards. Some of these processes are detailed in US Patent Nos. 3982045; 5246817; and 4847114. However, in the prior art processes, the circuits are made such that resistors, if required, need to be provided externally from the circuit board itself (eg. mounted on the surface of the circuit board as an appendage).

US-A-3522085 discloses a printed circuit board and a method of making the same in which a metal foil is adhered to a substrate of insulating material. The foil on specified portions of the substrate is etched away to leave a roughened surface on which is deposited for a predetermined time and for a predetermined quantity, a suitable resistive material.

The inventors herein have discovered a process whereby resistors can be printed and plated as an integral part of the circuitry of the printed circuit board. This provides for an efficient and economical way of providing the necessary resistors. In addition the process provides for further miniaturization of the printed circuit boards produced in comparison to those produced by prior art methods. Typical processes in this regard are US Patent Nos. 3808576 and 2662957.

According to a first aspect of the present invention there is provided a process for manufacturing a printed circuit board with integral plated resistors which process comprises: a) applying an etch resist onto portions of the metal surfaces of a metal clad laminate, which laminate comprises a dielectric substrate with metal cladding thereupon, such that the resist defines the desired circuitry in a positive manner and the areas between the circuits including the locations for the resistors in a negative manner thereby creating exposed metal surfaces and resist covered metal surfaces; b) etching away exposed metal surfaces thereby yielding metal circuits separated by exposed areas of the dielectric substrate; c) stripping the resist; d) treating the exposed areas of the dielectric substrate with a process selected from chemical etching, plasma etching, laser normalization, vapour blasting, sanding, shot blasting and sand blasting thereby uniformizing the dielectric substrate; e) activating the exposed areas of the dielectric substrate to accept plating thereon; f) applying a plating mask such that the plating mask covers all or substantially all of the surfaces except for the locations for the resistors; g) plating areas not covered by the plating mask with a resistive material; and h) stripping away the plating mask.

According to a second aspect of the present invention there is provided a printed circuit board comprising metal circuits upon and separated by a dielectric substrate wherein the metal circuits are connected at specific points by resistive material, which resistive material has been selectively plated upon the dielectric substrate and wherein the dielectric substrate have been treated with a process selected from chemical etching, plasma etching, laser normalization, vapour blasting, sanding, shot blasting and sand blasting thereby uniforming the dielectric substrate (10) prior to plating the resistive material.

In its preferred embodiment, the invention produces printed circuits with integral resistors, which resistors have a particularly constant resistance as is required by the most demanding applications.

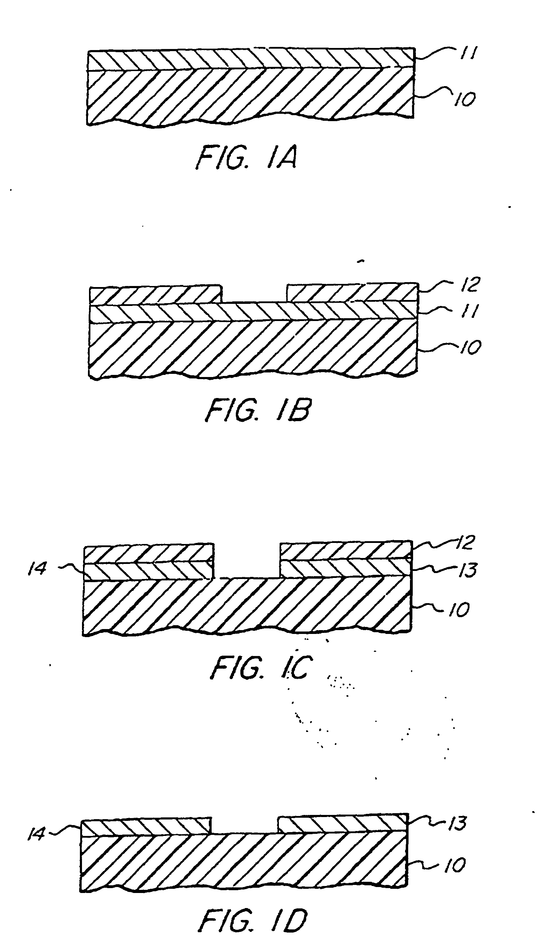

Embodiments of the present invention will now be described by way of example only, with reference to the accompanying drawings, in which:-
Figure 1A represents one side of the copper clad laminate (although both sides would most likely be processed in the same way) with insulating dielectric substrate, 10, and the attached copper foil, 11.
Figure 1B indicates the presence of an imaged resist, 12, on the copper foil, 11. The resist, 12, has already been imaged and developed and therefore covers only the desired portions of the copper foil, 11.
Figure 1C indicates that the exposed copper has now been etched away leaving unconnected resist covered copper traces, 13 and 14 on the substrate, 10.
Figure 1D indicates that the resist has now been completely stripped away leaving only the desired copper traces, 13 and 14 on the substrate, 10.

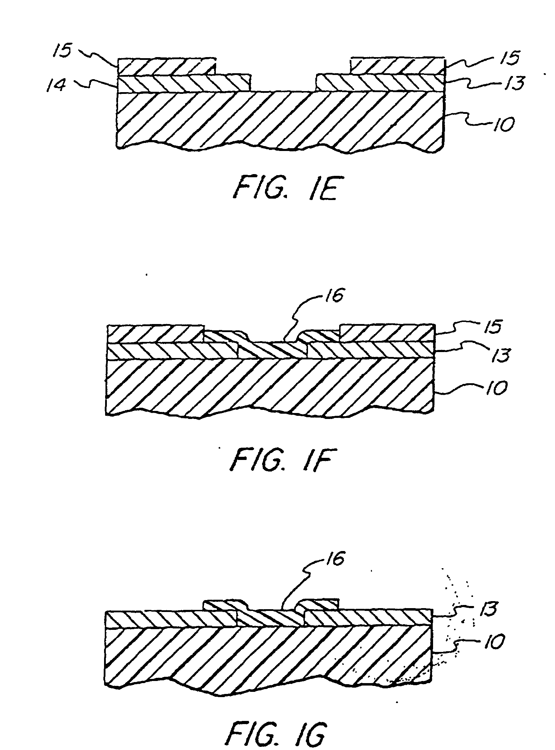

Figure 1E shows the application of a plating resist, 15, which covers the entire area of the board except the portions where the resistor will be plated.
Figure 1F shows the plated resistor 16, connecting the previously unconnected copper traces, 13 and 14.
Figure 1 G shows the circuit after the plating resist has been stripped away.

The current invention proposes a process for printing and plating resistors as an integral part of a printed circuit board. The foregoing process is described in its basic form by the following sequence of processing steps:
a) Apply an etch resist on the surface of a metal clad laminate (or multi-layer package) in a desired pattern. The desired pattern should preferably define the conductive circuits desired in a positive manner and should define the areas between the circuits and locations for the resistors in a negative manner;
b) Etch away the exposed copper and preferably remove the etch resist;
c) Treating at least portions of the exposed areas of the dielectric substrate with a process selected from chemical etching, plasma etching, laser normalisation, vapour blasting, sanding, shot blasting and sand blasting;
d) Activate the surfaces to accept plating thereon;
e) Apply a plating mask which covers substantially all of the surfaces except for the areas where the resistors are to be plated;
f) Plate the exposed areas with a resistive material; and
g) Strip away the plating mask.

As an equivalent to the foregoing process, foregoing steps a and b can be replaced by an additive process with the following steps:
a.1.). Activate the surfaces of a bare dielectric substrate to accept plating thereon;
a.2) Apply a plating mask to the dielectric substrate such that the desired circuits are defined in a negative manner and the areas between the circuits and the locations for the resistors are defined in a positive manner;
a.3) Plate the desired circuitry;
a.4.) Strip away the plating resist; and
Subsequently follow steps (c) through (g) noted previously.

The inventors have found that etching before step (d) to uniformize the dielectric surface will provide plated resistors with more constant and predictable resistance.

In a preferred embodiment, the plated resist material is contacted with an oxidant subsequent to step (f). The inventors have found that contacting the plated resist material with an oxidant, and thereby oxidizing the plated resist material in a controlled manner provides plated resistors with a higher more constant and reliable resistance. Intrinsic resistance increases via controlled oxidation.

In another preferred embodiment, the printed circuit board is subjected to a cleaning step subsequent to step (g) in order to remove any residual activator species from step (d) and to otherwise improve the surface insulation resistance of the board in general. The inventors have found the inclusion of this step to produce printed circuit boards in this regard with higher reliability.

The processes described herein provide a method of forming a resistor or between two conductive areas, which areas are upon and separated by an insulating substrate. The method described provides for plating a resistive material onto the insulating substrate, which is between the conductive areas, such that the resistive material connects the conductive areas. The processes described are particularly useful in producing printed circuit boards with plated resistors which are integral with the circuits. The most basic processing sequence is described as follows:
a). apply an etch resist onto the surfaces of a metal clad laminate such that the resist defines the desired circuitry in a positive manner and the areas between the circuits including the locations for the resistors are defined in a negative manner;
b). etch away exposed copper surfaces and strip the resist;
c). uniformize the exposed dielectric surfaces;
d). activate the surfaces to accept plating thereon;
e). apply a plating mask such that the plating resist covers all or substantially all of the surfaces except for the areas where the resistors are to be plated (ie. such that the resistor areas are defined in a negative manner;
f) plate the exposed areas;
g). optionally, contact the plated areas with an oxidant;
h). strip away the plating mask;
i). optionally, clean the surfaces of the printed circuit board; and
j). optionally, coat the resistors with a protective coating.

Steps (a) and (b) together call for the creation of defined circuitry on the surfaces of a metal clad dielectric laminate (or multilayer package - several layers of circuitry containing one or more innerlaycrs of circuitry which have been laminated into a single planar package. The innerlayers may or may not contain the plated resistors of this invention. If so then the innelayers may be fabricated by the process described herein). The metal clad laminate may optionally have thru holes in it in a desired array. The thru holes may or may not be plated at this point. The key here is the definition and creation of circuit pattern on the surfaces of the metal clad laminate along with the definition and creation of specific breaks in the circuitry where the resistors will be plated (the "resistor areas"). The length and width of the specific resistor areas will obviously directly impact the resistance achieved after plating.

The definition and creation of circuitry and the resistor areas can be accomplished in many ways. The most prevalent way is through the subtractive process as described in current steps (a) and (b). In the subtractive process, a metal (usually copper) clad laminate is used. The metal clad laminate comprises a planar dielectric substrate with metal foil adhered to both exterior surfaces. As discussed, the dielectric substrate is typically glass reinforced epoxy, but can also be a variety of other insulative materials known in the art. In any case a resist pattern is applied to the metal surfaces such that the resist defines the circuits in a positive manner and the areas between the circuits and the resistor areas in a negative manner. The most typical way of accomplishing this is to use a photoresist. In this case the photoresist is applied to the metal surfaces in either liquid or dry form. The photoresist is then selectively exposed to actinic radiation through a negative. The unexposed areas of the resist are developed away revealing the desired pattern. As an alternative the resist may be screened onto the metal surfaces directly in the desired pattern. After the circuits are defined with the resist, the exposed copper areas are etched away and the resist is stripped revealing the circuits. Thus the areas between the circuits and the resistor areas are now bare dielectric.

In order for the resistors to be usable and reliable the resistance must be predictable, relatively constant and reliable. The inventors have found that in order to achieve plated resistors with predictable, relatively constant and reliable resistance, the dielectric surface to be plated with the resistor must be uniform. In this regard the inventors have achieved dielectric surface uniformity and predictable, relatively constant and reliable resistance of the plated resistors by uniformizing the dielectric surface upon which the resistor is to be plated (step c). Uniformizing can be achieved in several ways such as, vapor blasting, chemical etching, plasma etching laser normalization, or mechanical uniformization Mechanical uniformization can be achieved by sanding, sand blasting or shot blasting. The inventors have found that surface . uniformization through chemical etching to be the mostreliableland efficient means. The particular etchant used in this regard must be matched with the dielectric being used. However, if glass reinforced epoxy is used, the inventors have found that alkaline permanganate, concentrated sulfuric acid, chromic acid or plasma to be particularly useful in etching and uniformizing the surface of the dielectric. Solutions of sodium or potassium permanganate at concentrations in excess of 50 gams/litre, in 10% by weight caustic solution, at temperatures in excess of 60°C (140°F) and for times of 2 to 20 minutes are preferred in this regard. If permanganates are used in this regard they may be preceded with a swellant or sensitizer which makes the dielectric more susceptible to the permanganate etch. A typical swellant for epoxy is m-pyrol applied full strength at from 32-49°C (90-120°F) for from 1 to 5 minutes. In addition the permanganate etch is typically followed by an acid reducing solution which will remove the permanganate residues.

Step (d) involved activating the surfaces to be plated. Activation of the surfaces can range in complexity from a single dip in a precious metal activator (or non-precious metal or other activators know in the art) to a full plating cycle involving numerous steps. Typically the activation process will begin with a conditioner (surfactant or other type), followed by an activator (PdCl₂/SnCl₂ Colloid) and an accelerator. Clean water rinses are interposed between each chemical treatment. Regardless of the activation cycle chosen, its primary purpose is to treat the surfaces such that they initiate and accept plating. A wide variety of methods for achieving this are known in the art, any of which may be advantageously utilized here. Please refer to U.S. Patent Nos. 5,032,427 (Kukanskis, et al.), 4,976,990 (Bach et al.) and 4,863,758 (Rhodenizer).

In step (e) a plating mask is applied such that the resistor areas are defined in a negative manner. Generally, to accomplish this, the plating mask covers all or substantially all of the surfaces except for the resistor areas. The inventors have found that the plated resistors are more reliable if the plating mask allows for some plating overlap where the resistive plating meets the conductive circuit as opposed to covering all of the circuit with plating mask and causing the resistive plating to merely abut the conductive circuit. In any case, the plating mask can be any typical plating mask known in the art as long as it maintains its integrity in the subsequent plating bath. The plating mask may be screened onto the surface in the desired pattern or blanket coated, photoimaged and developed.

Step (f) involves plating the resistors. At this stage the plating will occur only on the areas not covered by the plating mask (ie. the resistor areas, preferably with some overlap onto the circuits where the resistor connects to the circuits). A variety of plating baths can be advantageously utilized. The inventors have found electroless nickel-phosphorous, electroless precious metal plating baths, including palladium-phosphorous, electroless plating baths, to be particularly useful in this regard. It may be optionally desirable to clean and/or accelerate the surfaces prior to plating.

Obviously, the thickness of the metal plated has a direct impact on the resistivity of the resultant resistor. The inventors have found that typically it is advantageous to plate metal thickness in the range of from 0.05 x 10⁻⁶ to 2.5 x 10⁻⁶ m (0.05 to 2.5 microns), and more preferable from 0.1 x 10⁻⁶ to 0.50 x 10⁻⁶m (0.10 to 0.50 microns). Plating advantageously takes 2 to 3 minutes, more preferably 5 to 10 minutes, depending upon the plating bath used and the ultimate resistance desired.

Depending upon the ultimate resistance desired, the following factors may be adjusted to vary the resistivity of the resultant resistor: type of metal plated, thickness of the metal plated, length of the resistor and, width of the resistor. With regard to type of metal plated, the phosphorous content of the nickel-phosphorous or the palladium-phosphorous, will affect the resistivity of the final deposit. All of the foregoing factors may be varied to achieve the ultimate resistance desired. The inventors have found that the intrinsic resistance of the nickel or palladium plated increases with phosphorous content of the metal. They have also found it most advantageous to plate the resistors with nickel having a phosphorous content of 10 - 13% by weight and palladium with a phosphorous content of 2 - 8% by weight. The inventors have found that high phosphorous containing metals, particularly nickel or palladium, produce a plated coating with relatively high intrinsic resistance. Therefore for any given desired ultimate resistance for the resistor, a greater thickness of material (holding length and width constant) can be plated, thereby yielding more reliable plated resistors. This also allows for commercially acceptable plating times in the range of 2-3 minutes. Plating times of less than 2-3 minutes are too short to easily control in a commercial process with reliability, thereby producing relatively unreliable plated resistors. If resistors of different resistances are required on the same circuit board, then steps (e) and (f) or (d), (e) and (f) can be repeated to plate different resistors with different thicknesses of resistive material or with different resistive material. Alternatively, of course, other variables such as length and width of the resistors can be varied without repeating any steps.

Step (g) optionally provides for controlled oxidation of the plated resistor metal. The inventors have discovered that controlled oxidation is a method for increasing the resistance of the plated resistor and of providing for more reliable resistance on a consistent basis. In this regard a variety of oxidants may be used including potassium iodate, which is preferred. If potassium iodate is used an aqueous solution with from 10-75 gr/l potassium iodatc at a temperature of 90°C and for a time of 5 minutes has proven effective. Here again the higher intrinsic resistance products allows for greater thickness of plated material (other variable constant), more reliable plated resistors and commercially acceptable plating times. The inventors have found that increases in instrinsic resistance of the plated metal of from 20 to 400 percent based upon the intrinsic resistance of the same unoxidized metal can be achieved.

Step (h) involves stripping away the plating mask. A stripping solution must be chosen to match the plating mask used. Typical plating masks can be stripped away in alkaline solution, however some require organic solvents.

At this point, step (i), it is optionally advantageous to clean the surfaces of the printed circuit board in order to remove any residual activator and to increase the surface insulation resistance of the board. U.S. Patent Numbers 5,221,418; 5,207,867; and 4,978,422, all teach various means of cleaning and increasing the surface insulation resistance of boards as is suggested by step (i) herein. Care must be taken such that the resistance of the plated resistor is not affected by the foregoing cleaning. It may be advantageous to protect the plated resistors, prior to cleaning the circuits as noted above, through use of a coating of some type, permanent or non-permanent.

Finally, it is usually desirable to coat the surfaces ofthe board, including the plated resistors, with a protective coating such as a soldermask. Soldermasks are desirable for the protection of the board in subsequent processing and to enhance the durability of the resulting product. Typical solder mask processing is described in U.S. patent No. 5,296,334,

The following examples are presented for illustrative purposes only and should not be taken as limiting in any way. Example I is not in accordance with the invention as claimed in the claims, but is retained in the description for completeness and clarity as Examples II and III refer back to Example I.

### Example I

Copper clad glass reinforced epoxy laminates were processed through the following sequence:
1. A dry film resist (Aquamer CF-1.5 available from MacDermid Imaging Technology, Inc.) was laminated to both copper surfaces of the laminate. The resist was then selectively exposed to ultraviolet light by exposure through a negative. The negative was designed such that the ultraviolet light impinged upon the circuit areas only. (ie. circuits defined in a positive manner and the areas between circuits and resistor areas are defined in a negative manner) The unexposed portions of the resist were developed away using a 1% by weight potassium carbonate solution at 33°C (90°F) for 30 seconds.
2. The exposed copper surfaces were etched away by spraying ammoniacal copper chloride etchant at 44°C (110°F°) onto the surfaces until the exposed copper was cleanly etched away. The resist was then stripped away in a 10% by weight caustic solution.
3. The surfaces were activated to accept plating thereon by the following process sequence.
   a) MacDermid M-Conditioner 44°C (110°F), 2 minutes
   b) MacDermid M-Preactivator, 24°C-(75°F), 2 minutes
   c) MacDermid M-Activator 38°C (100°F), 5 minutes
   Clean water rinses were interspersed between each of the foregoing steps.
4. MacDermid Viatek PM #4 plating mask was then screened onto the surfaces such that it covered all of the surfaces except for the areas where the resistors were to be plated (the "resistor areas") (ie. such that the resistor areas were defined in a negative manner). The plating mask was then baked to cure for 5 minutes at 121°C (250°F). The width and length of the resistor areas, resistivity of electroless palladium-phosphorous, and the thickness of the palladium-phosphorous plate were used to design and predict the ultimate resistance of the plated resistors.
5. The resistor areas were then plated by immersion in MacDermid Pallas 52 electroless palladium-phosphorous plating bath, which was prepared per the supplied data sheet, at 66°C (150°F) for 5 minutes. Approximately 0.1x10⁻⁶ to 0.2 to 10⁻⁶m (0.1 to 0.2 microns) of electroless palladium-phosphorous were plated.
6. The plating mask was then stripped away using a 10% by weight caustic solution at 66°C (150°F) for 2 minutes and then thoroughly rinsed.

The boards were then electrically tested to determine the actual resistance of the plated resistors and the actual resistance was compared to the design resistance. Variances of 25-30% were recorded.

### Example II

Copper clad glass reinforced epoxy laminates were processed through the same sequence as in the Example I except that after step 2 and before step 3 the following additional processing was inserted:
a) M-Pyrol, 100% by weight, 33°C (90°F), 2 minutes
b) Potassium permanganate, 60 gr/l, 10% by weight caustic soda, 71°C. (160°F), 10 minutes
c) 10% by weight hydrochloric acid, 5 gr/l hydroxylamine sulfate, 44°C (110°F), 5 minutes

The boards were then electrically tested to determine the actual resistance of the plated resistors and the actual resistance was compared to the design resistance. Variances of 8-10% were recorded.

### Example III

Copper clad glass reinforced epoxy laminates were processed through the same sequence as in Example II except that at the end of the processing as indicated in Example II the following sequence was performed:
The resistors were oxidized by immersing the boards in an aqueous solution of 40 gr/l of potassium iodate at 90°C for 5 minutes.

The boards were then electrically tested to determine the actual resistance of the plated resistors. Actual resistance has increased by 300% as compared to the unoxidized resistors of Example II. Variances of 5 to 10 % were recorded.

## Claims

1. A process for manufacturing a printed circuit board with integral plated resistors which process comprises:
a) applying an etch resist (12) onto portions of the metal surfaces (11) of a metal clad laminate, which laminate comprises a dielectric substrate (10) with metal cladding (11) thereupon, such that the resist (12) defines the desired circuitry in a positive manner and the areas between the circuits including the locations for the resistors in a negative manner thereby creating exposed metal surfaces and resist covered metal surfaces;
b) etching away exposed metal surfaces thereby yielding metal circuits (13,14) separated by exposed areas of the dielectric substrate (10);
c) stripping the resist (12);
d) treating of the exposed areas of the dielectric substrate (10) with a process selected from chemical etching, plasma etching, laser normalization, vapour blasting, sanding, shot blasting and sand blasting thereby uniformizing the dielectric substrate (10);
e) activating the exposed areas of the dielectric substrate (10) to accept plating thereon;
f) applying a plating mask (15) such that the plating mask covers all or substantially all of the surfaces except for the locations for the resistors;
g) plating areas not covered by the plating mask (15) with a resistive material (16); and
h) stripping away the plating mask (15).

2. The process according to claim 1 wherein the resistive material (16) is exposed to an oxidant subsequent to step (g).

3. The process according to claim 1 or claim 2 wherein the printed circuit board is cleaned subsequent to step (h).

4. The process according to any previous claim wherein a permanent protective coating is applied to the printed circuit board subsequent to step (h).

5. The process according to any previous claim wherein the resistive material (16) is plated to a thickness of from 0.05 x 10⁻⁶ to 2.5 x 10⁻⁶m.

6. The process according to any previous claim wherein the resistive material (16) is selected from electroless nickel-phosphorous and electroless palladium phosphorous.

7. A printed circuit board comprising metal circuits (13,14) upon and separated by a dielectric substrate (10) wherein the metal circuits (13,14) are connected at specific points by resistive material (16), which resistive material (16) has been selectively plated upon the dielectric substrate (10) and wherein the dielectric substrate (10) have been treated with a process selected from chemical etching, plasma etching, laser normalization, vapour blasting, sanding, shot blasting and sand blasting thereby uniformizing the dielectric substrate (10) prior to plating the resistive material (16).

8. The printed circuit according to claim 7 wherein the resistive material (16) is plated to a thickness of from 0.05 x 10⁻⁶ to 2.5 x 10⁻⁶m.

9. The printed circuit according to claim 7 or claim 8 wherein the resistive material (16) is selected from electroless nickel-phosphorous and electroless palladium-phosphorous.

## Patentansprüche

1. Verfahren zum Herstellen einer Leiterplatte mit integrierten galvanisierten Widerständen mit folgenden Schritten:
a) Aufbringen eines Fotolacks (12) auf Abschnitte der Metalloberflächen (11) eines Metall kaschierten Laminats, wobei das Laminat ein dielektrisches Substrat (10) mit einer aufgebrachten Metallkaschierung (11) umfasst, so dass der Fotolack (12) die gewünschten Schaltung auf positive Weise definiert und die Bereiche zwischen der Schaltung einschließlich der Stellen für die Widerstände auf eine negative Weise definiert, wobei dadurch freigelegte Metallflächen und durch Fotolack bedeckte Metallflächen erzeugt werden;
b) Wegätzen freiliegender Metallflächen, so dass Schaltkreise (13, 14) aus Metall erhalten werden, die durch die freiliegenden Flächen des dielektrischen Substrats (10) getrennt sind;
c) Entfernen des Fotolacks (12);
d) Behandeln der freiliegenden Flächen des dielektrischen Substrats (10) mit einem Verfahren, das aus einem der Verfahren chemisches Ätzen, Plasmaätzen, Lasernormalisieren, Dampfstrahlen, Schleifen, Strahlputzen und Sandstrahlen ausgewählt ist, wodurch das dielektrische Substrat (10) geglättet wird;
e) Aktivieren der freiliegenden Flächen des dielektrischen Substrats (10), so dass diese galvanisierbar sind;
f) Aufbringen einer Galvanisiermaske (15), so dass die Galvanisiermaske alle oder im wesentliche alle Flächen außer dem Bereichen für die Widerstände bedeckt;
g) Galvanisieren der Fläche, die nicht durch die Galvanisiermaske (15) mit einem Resistmaterial (16) bedeckt sind; und
h) Entfernen der Galvanisiermaske (15).

2. Verfahren nach Anspruch 1, wobei das Resistmaterial (16) nach dem Schritt (g) einem Oxidant ausgesetzt wird.

3. Verfahren nach Anspruch 1 oder 2, wobei die Leiterplatte nach dem Schritt (h) gereinigt wird.

4. Verfahren nach einem der vorangehenden Anspräche, wobei eine permanente Schutzbeschichtung auf die Leiterplatte nach dem Schritt (h) aufgebracht wird.

5. Verfahren nach einem der vorangehenden Ansprüche, wobei das Resistmaterial (16) mit einer Dicke von 0,05 x 10⁻⁶ - 2,5 x 10⁻⁶ m aufgalvanisiert wird.

6. Verfahren nach einem der vorangehenden Ansprüche, wobei das Resistmaterial aus einem der Materialien autokatalytisches Nickel-Phosphor und autokatalytisches Paladium-Phosphor ausgewählt ist.

7. Leiterplatte mit aufgebrachten Metalleiterbahnen (13, 14), die durch ein dielektrisches Substrat (10) getrennt sind, wobei die Leiterbahnen (13, 14) an bestimmten Punkten durch ein Resistmaterial (16) verbunden sind, wobei das Resistmaterial (16) selektiv auf dem dielektrischen Substrat (10) aufgalvanisiert worden ist, und wobei das dielektrische Substrat (10) mit einem Verfahren behandelt worden ist, das aus einem der Verfahren chemisches Ätzen, Plasmaätzen, Lasernormalisieren, Dampfstrahlen, Schleifen, Strahlputzen und Sandstrahlen ausgewählt ist, wobei dadurch das dielektrische Substrat (10) vor dem Galvanisieren des Widerstandsmaterials (16) geglättet wird.

8. Leiterplatte nach Anspruch 7, wobei das Widerstandsmaterial (16) in einer Dicke in einem Bereich von 0,05 x 10⁻⁶ - 2,5 x 10⁻⁶ m aufgalvanisiert wird.

9. Leiterplatte nach Anspruch 7 oder 8, wobei das Widerstandsmaterial (16) aus autokatalytischem Nickel-Phosphor und autokatalytischem Paladium-Phosphor ausgewählt wird.

## Revendications

1. Procédé de fabrication d'une carte de circuit imprimé comportant des résistances plaquées, le procédé comprenant les étapes suivantes :
a) appliquer une résine de masquage (12) sur des parties des surfaces métalliques (11) d'un stratifié revêtu de métal, le stratifié comprenant un substrat diélectrique (10) et un revêtement métallique (11), de façon que la résine de masquage (12) définisse des circuits souhaités d'une manière positive et les zones situées entre les circuits, incluant les emplacements des résistances, d'une manière négative de façon à créer des surfaces métalliques exposées et des surfaces métalliques recouvertes par la résine de masquage ;
b) retirer par gravure les surfaces métalliques exposées de manière à obtenir des circuits métalliques (13, 14) séparés par des zones exposées du substrat diélectrique (10) ;
c) retirer la résine de masquage (12) ;
d) traiter les zones exposées du substrat diélectrique (10) selon un processus sélectionné parmi une gravure chimique, une gravure au plasma, un nivellement au laser, un sablage humide, un sablage, un grenaillage et un décapage au sable, de façon à uniformiser le substrat diélectrique (10) ;
e) activer les zones exposées du substrat diélectrique (10) pour que ces dernières acceptent un plaquage ;
f) appliquer un masque de plaquage (15) de façon que le masque de plaquage recouvre toutes ou sensiblement toutes les surfaces à l'exception des emplacements des résistances ;
g) plaquer les zones non recouvertes par le masque de plaquage (15) avec un matériau résistif (16) ; et
h) retirer le masque de plaquage (15).

2. Procédé selon la revendication 1, dans lequel le matériau résistif (16) est exposé à un oxydant à la suite de l'étape (g).

3. Procédé selon la revendication 1 ou 2, dans lequel la carte de circuit imprimé est nettoyée à la suite de l'étape (h).

4. Procédé selon l'une quelconque des revendications précédentes, dans lequel un revêtement protecteur permanent est déposé sur la carte de circuit imprimé à la suite de l'étape (h).

5. Procédé selon l'une quelconque des revendications précédentes, dans lequel le matériau résistif (16) est plaqué selon une épaisseur comprise entre 0,05 x 10⁻⁶ et 2,5 x 10⁻⁶ m.

6. Procédé selon l'une quelconque des revendications précédentes, dans lequel le matériau résistif (16) est sélectionné parmi le nickel phosphoreux non-électrolytique et le palladium phosphoreux non-électrolytique.

7. Carte de circuit imprimé comprenant des circuits métalliques (13, 14) séparés par un substrat diélectrique (10) dans laquelle les circuits métalliques (13, 14) sont reliés en des points spécifiques par un matériau résistif (16), ledit matériau résistif (16) ayant été plaqué sélectivement sur le substrat diélectrique (10), et dans laquelle le substrat diélectrique (10) a été traité selon un processus sélectionné parmi une gravure chimique, une gravure au plasma, un nivellement au laser, un sablage humide, un sablage, un grenaillage et un décapage au sable, de façon à uniformiser le substrat diélectrique (10) avant d'effectuer le plaquage de matériau résistif (16).

8. Circuit imprimé selon la revendication 7, dans lequel le matériau résistif (16) est plaqué selon une épaisseur comprise entre 0,05 x 10⁻⁶ et 2,5 x 10⁻⁶ m.

9. Circuit imprimé selon la revendication 7 ou la revendication 8, dans lequel le matériau résistif (16) est sélectionné parmi le nickel phosphoreux non-électrolytique et le palladium phosphoreux non-électrolytique.
